# EUROPÄISCHE PATENTSCHRIFT

(11) **EP 0 710 819 B1**
(45) Veröffentlichungstag und Bekanntmachung des Hinweises auf die Patenterteilung: **14.07.1999**
(21) Anmeldenummer: 95114910.3
(22) Anmeldetag: 21.09.1995
(51) Int. Cl.: G01D 18/00, H01L 27/144

(54) **Sensoreinheit für einen Drehgeber oder Lineargeber**
Sensor unit for an angular- or linear-position sensor
Unité de capteur pour un capteur de position angulaire ou linéaire

(30) Priorität: 05.11.1994 DE 4439693
(43) Veröffentlichungstag der Anmeldung: 08.05.1996
(73) Patentinhaber: HENGSTLER GMBH, D-78554 Aldingen (DE)
(72) Erfinder: Bauer, Robert, Dr. Dipl.-Ing., D-79319 Emmendingen (DE)
(74) Vertreter: Leitner, Waldemar, Dr. techn.

(56) Entgegenhaltungen:
- EP-A- 0 518 620
- GB-A- 2 212 020
- US-A- 4 945 231

## Beschreibung

Die Erfindung betrifft eine Sensoreinheit für einen Drehgeber oder Lineargeber, mit mindestens einer mehrere Photoelemente aufweisende Photoelemente-Anordnung, durch die Codierungselemente, die auf einem von der Photoelemente-Anordnung erfaßten und von den Lichtstrahlen einer Lichtquelle beaufschlagten Abschnitt einer Maßverkörperung angeordnet sind, abtastbar sind, und bei der die von den Photoelementen der Photoelemente-Anordnung erzeugten Ausgangssignale einer Auswerteschaltung zuführbar sind.

Eine derartige Sensoreinheit für einen Dreh- oder Lineargeber ist z. B. aus der EP 0526730 bekannt. Zwischen der Maßverkörperung und der in Durchlichttechnik betriebenen Photoelemente-Anordnung ist eine eine Vielzahl von Blendenschlitzen aufweisende Blendenplatte angeordnet, wobei die Anordnung der Blendenschlitze und die der Photoelemente der Anordnung der Codierungselemente auf der Maßverkörperung angepaßt und zugeordnet ist. Nachteilig hierbei ist, insbesondere bei einer hohen Auflösung und folglich bei eng nebeneinanderliegenden Codierungselementen, daß die Anordnung der Blendenschlitze der Blendenplatte in einem eng tolerierten, festen Verhältnis zu der durch die Codierungselemente vorgegebenen Code-Teilung auf der Maßverkörperung stehen muß. Ein derartiger Aufbau besitzt den Nachteil, daß bei der Herstellung sowohl der Code-Teilung auf der Maßverkörperung als auch bei der Fertigung der Blendenplatte äußerst enge Fertigungstoleranzen eingehalten werden müssen. Desweiteren muß beim Einbau dieser beiden Elemente in den Dreh- oder Lineargeber die gegenseitige mechanische Position eng toleriert werden, um exakte und vor allem über den gesammten Umfang oder die gesamte Länge der Maßverkörperung gleichmäßige Meßergebnisse zu erzielen. Die hierbei unabdingbar erforderlichen äußerst engen Toleranzen bei der Fertigung und bei der Montage erhöhen also in nachteiliger Art und Weise die Fertigungs- und die Montagekosten.

Es ist daher Aufgabe der Erfindung, eine Sensoreinheit der eingangs genannten Art derart weiterzubilden, daß ein vereinfachter Aufbau eines Dreh- oder Lineargebers erreicht wird. Außerdem soll ein Verfahren geschaffen werden, mit dem der Abgleich der Sensoreinheit auf eine Vielzahl von unterschiedlichen Maßverkörperungen besonders einfach durchführbar ist.

Diese Aufgabe wird erfindungsgemäß durch die im Kennzeichen des Anspruchs 1 und des Anspruchs 15 enthaltenen Merkmale gelöst.

Die erfindungsgemäße Sensoreinheit für einen Drehgeber oder Lineargeber zeichnet sich dadurch aus, daß es durch die erfindungsgemäßen Maßnahmen in besonders vorteilhafter Art und Weise möglich ist, die bisher unabdingbar erforderliche mechanisch-geometrische Korrelation zwischen der Code-Teilung der Maßverkörperung einerseits und der Blendenplatte und der bekannten Sensoreinheit andererseits aufzugeben, und von dieser statisch korrelierten Vorgangsweise zu einem dynamischen, selbstadaptierenden Prozeß überzugehen, der es in vorteilhafter Art und Weise erlaubt, durch eventuell vorhandene Ungenauigkeiten der Code-Teilung auf der Maßverkörperung, der Maßverkörperung selbst, der zwischen Maßverkörperung und Sensoreinheit angeordneten Blendeneinheit und/oder der übrigen mechanischen Bauteile des Dreh- oder Lineargebers hervorgerufene Fehler zu erkennen und zu kompensieren.

Die der Photoelemente-Anordnung erfindungsgemäß vorgeschaltete Schaltanordnung, durch die die einzelnen Photoelemente der Photoelemente-Anordnung selektiv ein- und ausgeschaltet werden können, erlaubt es in vorteilhafter Art und Weise, daß in einer Lernphase des mit der erfindungsgemäßen Sensoreinheit durchführbaren erfindungsgemäßen Verfahrens ein definierter Abschnitt der Codierungselemente, also die auf der Maßverkörperung vorgesehene Code-Teilung, sukzessive von jeweils einem Photoelement der Photoelemente-Anordnung abgetastet werden kann, indem das jeweils aktivierte Photoelement die durch den entsprechenden Abschnitt der Maßverkörperung transmittierte oder an diesem reflektierte Lichtmenge erfaßt. Dies wird für jedes einzelne Photoelement der Photoelemente-Anordnung durchgeführt und aus der dadurch gewonnenen Belichtungsverteilung wird die Code-Teilung auf der Maßverkörperung berechnet und diejenigen Photoelemente der Photoelemente-Anordnung ausgewählt, welche nach Abschluß dieser Phase des selbstadaptierenden Verfahrens im stationären Betrieb des Dreh- oder Lineargebers zur Detektion der Dreh- oder Linearbewegung herangezogen werden sollen.

Durch die erfindungsgemäßen Maßnahmen wird also nicht nur erreicht, daß eine einzige Sensoreinheit flexibel für eine Vielzahl von unterschiedlichen Maßverkörperungen eines Dreh- oder Lineargebers eingesetzt werden können, wodurch sich die Lagerhaltungskosten der Drehgeber- oder Lineargeber-Hersteller drastisch reduzieren. Vielmehr zeichnet sich der eine erfindungsgemäße Sensoreinheit verwendende Dreh- oder Lineargeber dadurch aus, daß eine Blende zwischen Maßverkörperung und den Photoelementen zur Erzielung einer hohen Auflösung nun nicht mehr unbedingt erforderlich ist. Außerdem ist es in vorteilhafter Art und Weise nun nicht mehr erforderlich, daß die Maßverkörperung und die Sensoreinheit in einer eng tolerierten mechanisch-geometrischen Beziehung zueinander stehen, da eventuelle Abweichungen von einer vorgegebenen Soll-Beziehung dieser beiden Bauteile durch den selbstadaptierenden Abgleichprozeß eliminiert oder zumindest weitgehendst kompensiert werden können.

Ein weiterer Vorteil der erfindungsgemäßen Sensoreinheit besteht darin, daß sie besonders einfach auf einem Halbleiterchip, insbesondere auf einem Opto-ASIC, integriert werden kann. Die dadurch erzielbare Miniaturisierung erlaubt es in vorteilhafter Art und Weise, den erfindungsgemäßen Sensor nicht nur in einem Durchlicht-, sondern auch in einem Auflichtverfahren zur Detektion der Bewegung der Maßverkörperung einzusetzen.

Vorteilhafte Weiterbildungen der Erfindung ergeben sich aus den Unteransprüchen.

Weitere Einzelheiten der Erfindung sind dem Ausführungsbeispiel zu entnehmen, das im folgenden anhand der Figuren beschrieben wird. Es zeigen:
- Figur 1: eine schematische Darstellung eines Ausführungsbeispiels im Durchlichtverfahren
- Figur 2: ein Blockschaltbild einer Sensoranordnung des Ausführungsbeispiels,
- Figur 3: eine Ausführungsform eines Inkrementalteils der Sensoranordnung des Ausführungsbeispiels,
- Figur 4: eine Ausführungsform eines Absolutteiles der Sensoranordnung des Ausführungsbeispiels,
und
- Figur 5: eine schematische Darstellung für das Auflichtverfahren

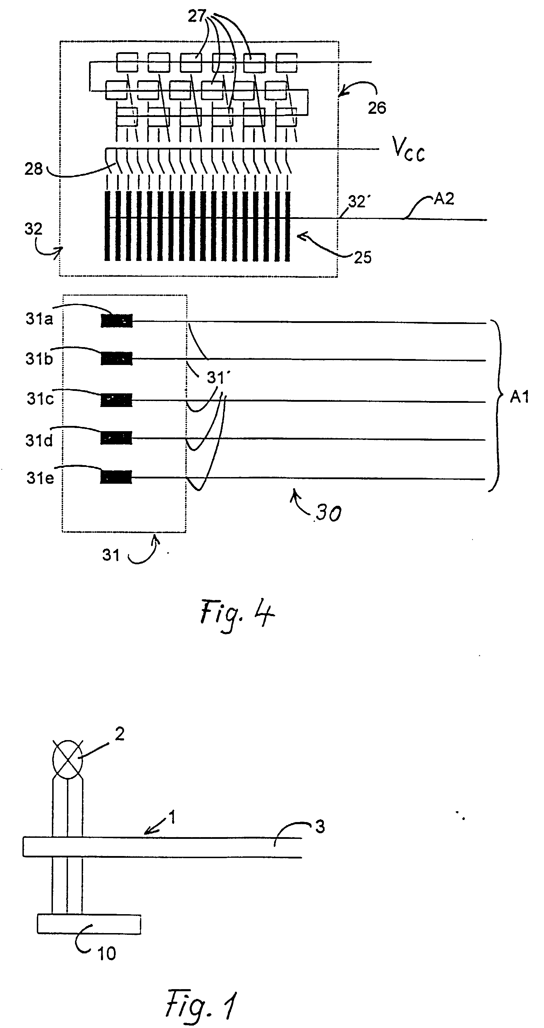

In Figur 1 ist schematisch der Aufbau eines allgemein mit 1 bezeichneten Drehgebers dargestellt, der im sogenannten Durchlichtverfahren betrieben wird. Das von einer passend gewählten Lichtquelle 2 emittierte Licht passiert eine in Figur 1 nicht dargestellten Code-Teilung einer eine Maßverkörperung repräsentierenden Codescheibe 3 und wird von den Photoelementen mindestens einer Photoelemente-Anordnung einer Sensoranordnung 10 des Drehgebers 1 registriert. In besonders vorteilhafter Art und Weise ist die Sensoranordnung 10 des beschriebenen Ausführungsbeispiels auf einem Halbleiterchip (Opto-ASIC) realisiert, der außer den bereits erwähnten Photoelementen der mindestens einen Photoelemente-Anordnung auch die weiter unten noch näher beschriebenen Schaltanordnung zur selektiven Aktivierung bzw. Deaktivierung dieser Photoelemente aufweist. Die Integration der eben genannten Bauelemente sowie eventuell einer die Ausgangssignale der Photoelemente der mindestens eine Photoelemente-Anordnung verarbeitenden Auswerteschaltung in einem einzigen Halbleiterchip stellt zwar die bevorzugte Ausgestaltung des beschriebenen Ausführungsbeispiels dar. Sie ist jedoch nicht die einzig mögliche Realisierungsart, da es dem Fachmann klar ersichtlich ist, daß die beschriebenen elektronischen Bauteile auch in diskreter Form vorgesehen werden können.

Die Zusammenfassung der Photoelemente auf einem gemeinsamen Chip bringt aber zusätzliche Vorteile in der optischen Auswertung und elektronischen Auslegung mit sich, da dadurch der Arbeitspunkt der optischen Elemente optimiert und der zur Verfügung stehende Freiheitsgrad zur Reduktion der Lichtleistung, zur Reduktion der optischen Fläche oder etwa zur Erhöhung der Grenzfrequenz verwendet werden kann. In jedem Fall verkleinert sich der Raumbedarf bei gleichzeitig entscheidender Erhöhung der Störfestigkeit. Positiv wirkt sich außerdem die geringe Streuung und das gleiche Temperatur- bzw. Alterungsverhalten des Gesamtsystems aus.

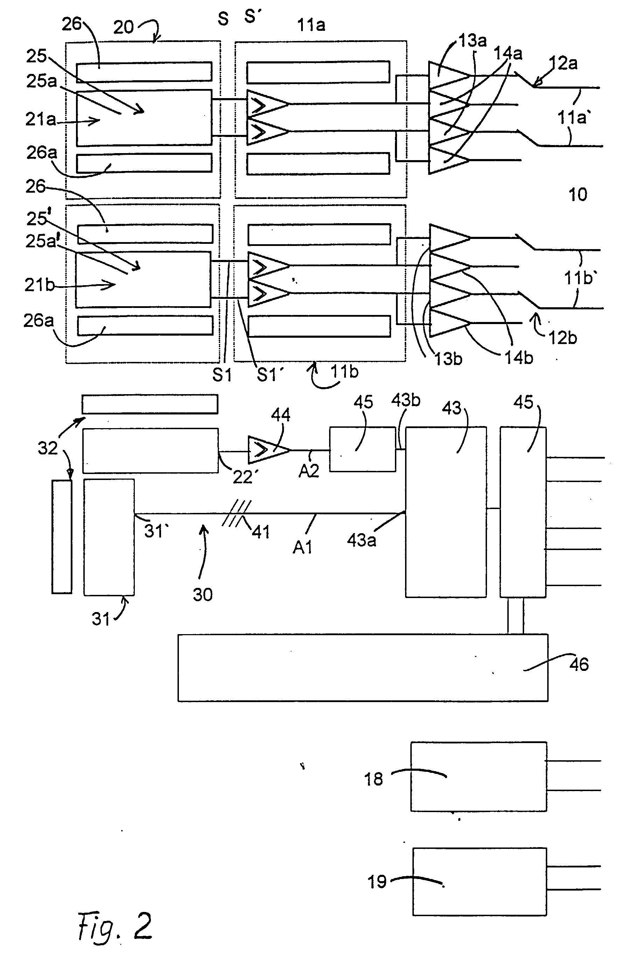

In Figur 2 ist nun das Blockschaltbild der Sensoranordnung 10 des beschriebenen Drehgebers 1 abgebildet. Diese Sensoranordnung 10 gliedert sich prinzipiell in einen Inkrementalteil 20 und einen Absolutteil 30, wobei der Inkrementalteil 20 zwei parallel arbeitende Sensoreinheiten 21a, 21b zur Erzeugung je eines Ausgangssignals durch die Abtastung je einer Code-Teilung der Codescheibe 3 aufweist, die jeweils vorzugsweise durch zwei gegenphasige optische Spuren gebildet wird. Das von jeder Sensoreinheit 21a, 21b des Inkrementalteiles 20 des Drehgebers 1 erzeugte Ausgangssignal S, S' bzw. S1, S1' wird jeweils einer an und für sich bekannten Auswerteschaltung 11a, 11b zugeleitet, in der nach einer Differenzverstärkung und Digitalisierung mit Hysterese (mit vorzugsweise digitalem Abgleich und Offset-Kompensation) die Abtastinformation durch die Funktionsblöcke 12a, 12b in an und für sich bekannter Art und Weise in analoger oder digitaler Form ausgegeben wird. Hierbei besteht - wie aus Fig. 2 ersichtlich ist - die Möglichkeit, wahlweise entweder über Komparatoren 13a, 13b Digitalsignale oder mittels entsprechender Verstärker 14a, 14b Analogsignale an die Ausgänge 11a', 11b' der Auswerteschaltungen 11a, 11b zu schalten.

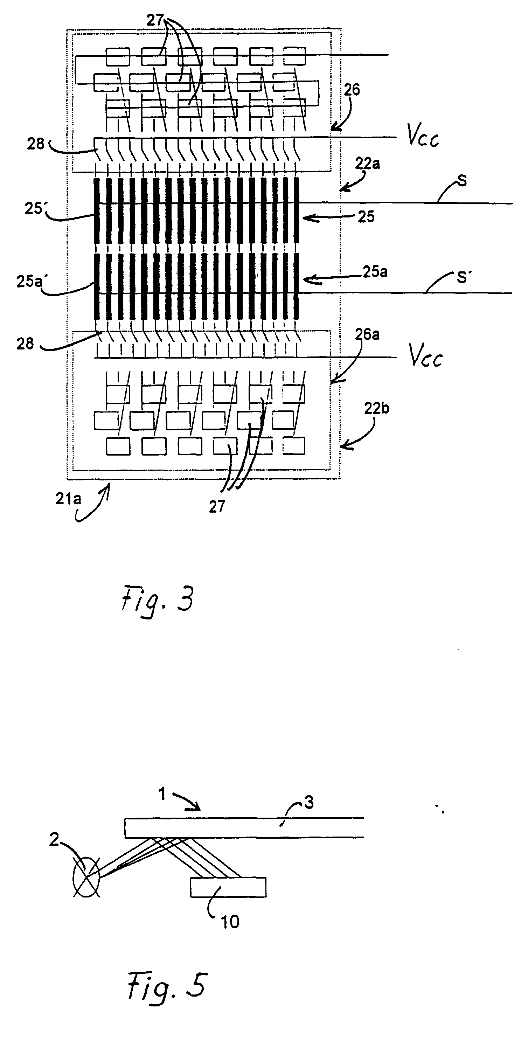

Der in Figur 4 noch detaillierter dargestellte Absolutteil 30 der Sensoreinheit 10 dient zur Abtastung einer auf der Codescheibe 3 angeordneten, die Absolutposition dieser Maßverkörperung repräsentierenden dritten Code-Teilung, wobei der aus einer Sensorstufe 31a für eine Grobauflösung des Absolutsignales und einer zweiten Sensorstufe 31b für eine Feinauflösung derselben bestehende Absolutteil 30 der Sensoranordnung 10 derart aufgebaut ist, daß die aus vorzugsweise fünf Photozellen bestehende erste Sensorstufe 31a an einen ersten Eingang 43a eines synchron-seriell arbeitenden Codewandlers 43 angeschlossen ist, während die ähnlich zu den Sensorelementen 21a, 21b des Inkrementalteiles 20 aufgebaute zweite Sensorstufe 31b des Absolutteils 30 über einen Komparator 44 und einen A/D-Wandler 45 an einen zweiten Eingang 43b des Codewandlers 43 angeschlossen ist. Die Photoelemente mit einer niedrigen Auflösung repräsentierenden Photozellen der ersten Sensorstufe 31a des Absolutteils 30 liefern beispielsweise die ersten vier Bit eines die absolute Position der Codescheibe 3 repräsentierenden binären Codeworts, das im Codewandler 43 durch ein Zusammensetzen des von der ersten Sensorstufe 31a erzeugten Ausgangssignals A1 und des am Eingang 43b anliegenden, im Analog/Digital-Wandler 45 in Digitalsignale umgesetzten Ausgangssignals A2 der zweiten Sensorstufe 31b gebildet wird. Der genaue Funktionsablauf der hier nur kurz umrissenen Signalverarbeitung der Ausgangssignale A1, A2 der beiden Sensorstufen 31a, 31b des Absolutteils 30 ist dem Fachmann geläufig und braucht daher nicht näher beschrieben zu werden. Es soll nur noch angeführt werden, daß es eine Steuerschaltung 46 in vorteilhafter Weise erlaubt, anstelle des o.g. digitalen Absolutsignals die Original-Kommutierungssignale auszugeben, wodurch erreicht wird, daß die beschriebene Sensoranordnung 10 auch für einfache Motorsteuerungen einsetzbar ist, die keine aufwendige A/D-Wandlung aufweisen.

Abschließend zur Figur 2 ist noch anzuführen, daß auf dem Chip auch noch andere, vorwiegend periphere Funktionen realisierende Funktionsblöcke, wie z. B. ein digitaler LED-Regler 18 oder ein Regler 19 für die Spannungsversorgung, implementiert sein können.

In Figur 3 ist nun im Detail eine der beiden identisch aufgebauten Sensoreinheiten 21a, 21b des Inkrementalteils 20 der Sensoranordnung 10 des Drehgebers 1 dargestellt. Aufgrund des identischen Aufbaus wird im folgenden nur mehr die Sensoreinheit 21a beschrieben: Diese weist vorzugsweise zwei identisch aufgebaute Sensorstufen 22a, 22b auf, um in an und für sich bekannter Art und Weise durch die simultane Abtastung der beiden gegenphasigen optischen Spuren eines Abtastkanals zwei Ausgangssignale S, S' erzeugen zu können, die durch eine Gegentaktverstärkung zu besonders rauscharmen Ausgangssignalen der Sensoranordnung 21a verarbeitet werden können. Es ist für den Fachmann selbstverständlich ohne weiteres Nachdenken ersichtlich, daß - wenn man gewillt ist, auf die Vorteile einer Gegentaktverstärkung zu verzichten - auch eine einzige Sensorstufe 22a zur Abtastung eines bestimmten Abschnitts der Codescheibe 3 ausreichend ist.

Jede Sensorstufe 22a bzw. 22b besitzt eine eine entsprechende Anzahl von Photoelementen 25' bzw. 25a' aufweisende Photoelemente-Anordnung 25 bzw. 25a, die in an und für sich bekannter Art und Weise der Abtastung des von der Codescheibe 3 reflektierten (Auflichtverfahren) oder durch diese hindurchtretenden (Durchlichtverfahren) Lichts dienen. Die Anzahl der Photoelemente 25', 25a' der Photoelemente-Anordnung 25, 25' wird daher im wesentlichen von der Breite des Abschnitts auf der Codescheibe 3 bestimmt, welcher von der Photoelemente-Anordnung 25, 25a gleichzeitig erfaßbar sein soll. Die Dimensionierung - insbesondere die Breite - der Photoelemente 25', 25a' wird wiederum im wesentlichen - wie aus der weiter unten folgenden Beschreibung der Funktionsweise des Ausführungsbeispiels noch klar ersichtlich werden wird - von der zu erzielenden Auflösung bestimmt.

Jeder Photoelemente-Anordnung 25, 25a ist eine Schaltanordnung 26, 26a vorgeschaltet, deren wesentlichste Funktion darin besteht, für jedes einzelne Photoelement 25', 25a' der Photoelemente-Anordnung 25, 25a einen programmierbaren Schalter bereitzustellen, durch den jedes einzelne Photoelement 25', 25a' vorwählbar mit der Versorgungsspannung Vcc verbindbar und damit selektiv aktivierbar oder deaktivierbar ist. Diese selektive Ansteuerbarkeit der einzelnen Photoelemente 25', 25a' der Photoelemente-Anordnung 25, 25a ist dabei vorzugsweise derart ausgebildet, daß in einer weiter unten noch näher erläuterten Justier- oder Lernphase jedes Photoelement 25', 25a' oder eine Gruppe von zusammenwirkenden Photoelementen 25a, 25a' einzeln aktivierbar sind, während in einer dieser Justier- oder Lernphase folgenden Betriebsphase gewährleistet sein muß, daß zu einem bestimmten Zeitpunkt, also bei einer definierten räumlichen Stellung der sich drehenden Codescheibe 3, eine definierte Auswahl der Photoelemente 25', 25a' der Photoelemente-Anordnung 25, 25a gleichzeitig aktiv ist.

Bei dem beschriebenen Ausführungsbeispiel wird diese von der Schaltanordnung 26, 26a bereitgestellte Steuerfunktion für die Photoelemente 25', 25a' der Photoelemente-Anordnung 25, 25a dadurch realisiert, daß die Schaltanordnung 26, 26a eine vorzugsweise nichtflüchtige Speichereinheit 27 - z. B. auf einer EEPROM-Basis - aufweist, die mit einer Schaltereinheit 28 zusammenwirkt, welche jeweils einen Schalter 28 für jedes Photoelement 25', 25a' der Photoelemente-Anordnung 25, 25a aufweist.

Die Funktionsweise des Inkrementalteiles 20 des Drehgebers 1 ist nun wie folgt:
Auf eine Welle, deren Drehbewegung vom Drehgeber 1 erfaßt werden soll, wird die Codescheibe 3 aufgebracht. Der Sensor des Drehgebers 1 wird montiert, wobei es aufgrund des nachstehend beschriebenen selbstadaptierenden Verfahrens in vorteilhafter Art und Weise nun nicht mehr erforderlich ist, daß der Sensor in einer eng tolerierten räumlichen Beziehung zur Codescheibe 3 fixiert ist. Vielmehr ist es ausreichend, wenn der Sensor an einem grob vorgegebenen Punkt relativ zur Codescheibe 3 angebracht wird.

Nach diesen vorbereitenden Maßnahmen erfolgt nun die Vermessung der durch die Codeelemente vorgegebenen Code-Teilung der Codescheibe 3, die in vorteilhafter Art und Weise selbstadaptierend erfolgt. Der von der Photoelemente-Anordnung 25, 25a erfaßbare Abschnitt der Maßverkörperung - im Falle der Codescheibe 3 also eines Kreissektors - wird sukzessive von jedem Photoelement 25', 25a' der Photoelemente-Anordnung 25', 25a abgetastet, indem in einer Abfolge von Teilschritten der Justier/oder Lernphase dieses selbstadaptierenden Verfahrens jeweils eine einzige oder eine definierte Gruppe von zusammenwirkenden, vorzugsweise nebeneinanderliegenden Photoelementen 25', 25a' der Photoelemente-Anordnung 25', 25a von der Schalteranordnung 26, 26a aktiviert wird und die Intensität des vom abgetasteten Sektor der Codescheibe 3 reflektierten Lichts registriert wird. Aus der aus der - vorzugsweise gesamten - Abfolge dieser Einzelmessungen gewonnenen Lichtverteilung wird dann die von den Sensoranordnungen 21a, 21b registrierte Code-Struktur der Codescheibe 3 ermittelt und aus dieser gemessenen, die Abbildung der Code-Teilung der Codescheibe 3 auf die photosensitive Fläche des Drehgebers 1 repräsentierenden Lichtverteilung werden nun diejenigen Photoelemente 25', 25a' der Photoelemente-Anordnung 25, 25a ermittelt, die zu einer den gestellten Anforderungen genügenden Auflösung der Photoelemente-Anordnung 25, 25a und somit der Sensorstufen 21a, 21b führen.

Nachdem die jeweils zu aktivierenden oder deaktiviert zu belassenen Photoelemente 25', 25a' der Photoelemente-Anordnung 25, 25a bestimmt wurde, wird im letzten Schritt dieser Lernphase des selbstadaptierenden Verfahrens die gefundene Verteilung der aktiven Photoelemente 25', 25a' im nicht-flüchtigen Speicher 27 der Schaltanordnung 26a, 26b abgelegt. Die Verwendung von nicht-flüchtigen Speichern besitzt hierbei den Vorteil, daß der beschriebene Drehgeber 1 keine intelligente Logik aufweisen muß, da die in der vorher beschriebenen Lernphase durchzuführenden Schritte in besonders vorteilhafter Art und Weise von einem über eine entsprechende Schrittstelle ankoppelbaren externen Rechner durchgeführt werden können.

Wenn die durch die Codeelemente der Codescheibe 3 aufgeprägte Code-Teilung des abgetasteten Sektors der Codescheibe 3 über deren gesamten Umfang konstant ist - wie es im allgemeinen bei einer mit einer äquidistanten Verteilung versehenen Maßverkörperung der Fall ist - so ist es ausreichend, bei stillstehender Codescheibe 3 den von der Photoelemente-Anordnung 25, 25a erfaßten Sektor abzutasten und auf der Basis der bei dieser Abtastung gewonnenen Lichtverteilung die Photoelemente-Verteilung wie oben beschrieben zu bestimmen. Im Falle einer nicht äquidistanten Teilung oder im Falle von nicht-vernachlässigbaren Axial- oder Radialabweichungen der Codescheibe 3 von ihrer Soll-Drehachse kann es jedoch erforderlich sein, den oben beschriebenen selbstadaptierenden Abgleichvorgang für zwei oder mehrere - oder sogar alle - Sektoren der Codescheibe 3 durchzuführen und für jeden derartigen Abschnitt der Codescheibe 3 getrennt die jeweils optimale Verteilung der aktiven Photoelemente 25', 25a' der Photoelemente-Anordnung 25, 25a zu bestimmen. In diesem Fall kann ein komplizierter aufgebauter vorzugsweise nicht-flüchtiger Speicher erforderlich sein, in dem die unterschiedlichen Photoelemente-Verteilungen als Funktion des jeweiligen Drehwinkels der Codescheibe 3 oder der Linearverschiebung einer Maßverkörperung eines Lineargebers abgespeichert sind.

Eine weitere denkbare Variante des beschriebenen selbstadaptierenden Prozesses besteht darin, daß dieser Adaptionsvorgang während der weiteren Betriebszeit des Drehgebers 1 kontinuierlich, quasi-kontinuierlich oder in diskreten Zeitabständen durchgeführt wird. Eine derartige Vorgehensweise besitzt den Vorteil, daß hierbei veränderte Bedingungen - wie die Erhöhung eines Radialschlags der Codescheibe 3, eine durch Alterung der Lichtquelle 2 oder der Codeelemente der Codescheibe 3 hervorgerufene Kontrastabnahme, etc. - berücksichtigt werden können. In vorteilhafter Art und Weise werden dann die Schalter 28 der Schaltanordnung 26 von einem neuronalen Netzwerk angesteuert.

Die oben beschriebene Bestimmung der Verteilung der aktiven Photoelemente 25', 25a' der Photoelemente-Anordnung 25, 25a kann verbessert werden, indem in einer der oben beschriebenen ersten Lernphase folgenden zweiten Lernphase eine Feinabstimmung durchgeführt wird, bei der - ggf. durch "Trial and Error"-Methoden - die in der ersten Lernphase generierte Verteilung der aktiven Photoelemente derart verändert wird, daß eine Optimierung des Ausgangssignals S, S' bzw. S1, S1' der jeweiligen Sensoranordnung 21a, 21b erreicht wird.

Soll der beschriebene Drehgeber 1 lediglich als Inkrementalgeber arbeiten, so kann der nachfolgend beschriebene, in Figur 4 dargestellte Absolutteil 30 ersatzlos entfallen. Anderenfalls ist der Absolutteil 30 vorzugsweise wie die in Figur 4 dargestellte Ausführungsform aufgebaut, wobei es aber auch durchaus möglich ist, ein bekanntes anderes System zur Abtastung einer entsprechenden einen Absolut-Abtastkanal repräsentierenden Code-Teilung der Codescheibe 3 zu verwenden.

Der Absolutteil 30 des Drehgebers 1 weist eine aus einer entsprechenden Anzahl von Photoelementen 31a-31e (im beschriebenen Ausführungsbeispiel 5) bestehende Grob-Abtaststufe 31 auf, wobei die in dieser Einheit 31 eingesetzten Photoelemente 31a-31e von deutlich niedrigerer Auflösung als die Photoelemente 25', 25a' der oben beschriebenen Fotoelemente-Anordnungen 25, 25a des Inkrementalteils 20 des Drehgebers 1 sein können. Diese vorzugsweise als einfache Photozellen ausgebildeten Photoelemente 31a-31e sind bevorzugt senkrecht unter der Codescheibe 3 angeordnet und dienen zur Grobabtastung der die Absolutinformationen repräsentierenden Spur der Codescheibe 3. Ein am Ausgang 31' (siehe Fig. 2) dieser Grob-Abtaststufe 31 auftretendes Ausganssignal A1 wird - wie bereits oben anhand der Figur 2 beschrieben - zum ersten Eingang 43a des Code-Wandlers 43 geleitet.

Eine weitgehend ähnlich mit den Sensoranordnungen 21a, 21b des Inkrementalteiles 20 des Drehgebers 1 aufgebaute Fein-Abtaststufe 32 wird in der gleichen Art und Weise wie die Sensoranordnungen 21a, 21b adaptiert, so daß auf eine ausführliche Beschreibung des Adaptionsvorgangs der Fein Abtaststufe 32 des Absolutteils verzichtet werden kann. Ein am Ausgang 32' auftretendes Ausgangssignal A2 wird über den Komparator 44 und den A/D-Wandler 45 zum zweiten Eingang 43b des Codewandlers 43 geleitet, in dem - wie bereits beschrieben - aus dem Ausgangssignal A1 der Grob-Abtaststufe 31 und dem A2 der Fein-Abtaststufe 32 ein die Absolutposition der Codescheibe 3 repräsentierendes digitales Absolutsignal generiert wird, das über eine serielle Schnittstelle, vorzugsweise nach den SSI-Format oder nach einem asynchronen Format abgegeben wird.

In Figur 5 ist nun schematisch der Aufbau des Drehgebers 1 für ein sogenanntes Auflichtverfahren dargestellt, bei dem das von der Lichtquelle 2 emittierte Licht an der in Figur 5 ebenfalls nicht dargestellten Code-Teilung der Codescheibe 3 reflektiert und von den Photoelementen der Sensoranordnung 10 des Drehgebers 1 registriert wird.

## Patentansprüche

1. Sensoreinheit für einen Drehgeber oder Lineargeber, mit mindestens eine mehrere Photoelemente (25',25a') aufweisende Photoelemente-Anordnung (25, 25a), durch die Codierungselemente, die auf einem von der Photoelemente-Anordnung (25, 25a) erfaßten und von den Lichtstrahlen einer Lichtquelle (2) beaufschlagten Abschnitt einer Maßverkörperung (3) angeordnet sind, abtastbar sind, und bei der die von den Photoelementen (25', 25a') der Photoelemente-Anordnung (25, 25a) erzeugten Ausgangssignale (S, S'; S1, S1') einer Auswerteschaltung (11a, 11b) zuführbar sind, dadurch gekennzeichnet, daß der Photoelemente-Anordnung (25a, 25a) eine Schaltanordnung (26, 26a) vorgeschaltet ist, durch die die Photoelemente (25' und 25a') der Photoelemente-Anordnung (25, 25a) selektiv aktivierbar und deaktivierbar sind, so daß in einer Adaptionsphase ein definierter Abschnitt der Codierungselemente der Maßverkörperung (3) von mindestens einem Photoelement (25', 25a') der Photoelemente-Anordnung (25, 25a) abtastbar ist, um im wesentlichen eine Zuordnung zwischen einem jeden Codierungselement der Maßverkörperung (3) und dem diesen Codierungselement zugeordneten Photoelement (25', 25a') festzulegen, daß die Ausgangssignale (A, A') aller zu einem bestimmten Zeitpunkt aktiven Photoelemente (25', 25a') der Photoelemente-Anordnung (25, 25a) der Auswerteschaltung (11a, 11b) zuführbar sind, und daß durch die Auswerteschaltung (11a, 11b) die Ausgangssignale der jeweils aktiven Photoelemente (25', 25a') der Photoelemente-Anordnung (25a, 25a) registrierbar sind, und daß aus der dadurch gewonnenen Verteilung der Lichtintensität über die Photoelemente (25', 25a') der Photoelemente-Anordnung (25, 25a) eine auf die Struktur der Codierungselemente der Maßverkörperung (3) adaptierte Auswahl der zu einem definierten Zeitpunkt zu aktivierenden Photoelemente (25', 25a') bestimmbar ist.

2. Sensoreinheit nach Anspruch 1, dadurch gekennzeichnet, daß die Schaltungsanordnung der Photoelemente (25', 25a') durch ein Ausleseverfahren derart wählbar ist, daß aus einer Photoelemente-Anordnung (25, 25a) nur einen einzigen Kanal repräsentierende Ausgangssignale (A, A') erzeugbar sind.

3. Sensoreinheit nach Anspruch 1, dadurch gekennzeichnet, daß die Schaltungsanordnung der Photoelemente (25', 25a') durch ein Ausleseverfahren derart wählbar ist, daß aus einer Photoelemente-Anordnung (25, 25a) verschiedene, in ihrer Phase verschobene Ausgangssignale (A, A') auf verschiedenen Kanälen erzeugbar sind.

4. Sensoreinheit nach einem der Ansprüche 1 bis 3, dadurch gekennzeichnet, daß in der Schaltanordnung (26, 26a) Informationen über die zu einem definierten Zeitpunkt zu aktivierenden oder deaktivierenden Photoelemente (25', 25a') der Photoelemente-Anordnung (25, 25a) abspeicherbar sind.

5. Sensoreinheit nach Anspruch 4, dadurch gekennzeichnet, daß die Schaltanodnung (26, 26a) mindestens einen nicht-flüchtigen Speicher (27) aufweist.

6. Sensoreinheit nach einem der Ansprüche 1 bis 5, dadurch gekennzeichnet, daß die Schaltanordnung (26, 26a) eine Schnittstelle aufweist, über die der Speicher (27) der Schaltanordnung (26, 26a) programmierbar ist.

7. Sensoreinheit nach einem der Ansprüche 1 bis 6, dadurch gekennzeichnet, daß die Schaltanordnung (26, 26a) für jedes Photoelement (25', 25a') oder für jede Gruppe von zusammenwirkenden Photoelementen (25', 25a') einen Schalter (28') aufweist, desen Schaltzustände im Speicher (27) der Schaltanordnung (26, 26a) abspeicherbar sind.

8. Sensoreinheit nach einem der Ansprüche 1 bis 7, dadurch gekennzeichet, daß die Photoelemente (25', 25a') der Photoelemente-Anordnung (25, 25a) äquidistant angeordnet sind, oder daß die Photoelemente (25') der ersten Photoelemente-Anordnung (25) gegenüber den Photoelementen (25a') der weiteren Photoelemente-Anordnung (25a) versetzt angeordnet sind.

9. Sensoreinheit nach einem der Ansprüche 1 bis 8, dadurch gekennzeichnet, daß die erste Photoelemente-Anordnung (25) und/oder die weitere Photoelemente-Anordnung (25a) sowie die erste Schaltanordnung (26) und/oder die weitere Schaltanordnung (26a) auf einem Halbleiterchip implementiert sind, daß auf dem Halbleiterchip die die Ausgangssignale (S, S'; S1, S1') der Photoelemente-Anordnung (25, 25a) verarbeitende Auswerteschaltung (11a, 11b) implementiert ist, und daß auf dem Halbleiterchip Hilfsfunktionen für die Photoelemente (25a, 25a') der Photoelemente-Anordnung (25, 25a) ausführende Funktionsblöcke (18, 19) implementiert sind.

10. Sensoranordnung mit einer Sensoreinheit (21a, 21b) nach mindestens einem der Ansprüche 1 bis 9, dadurch gekennzeichnet, daß die Sensoranordnung (10) ein Absolutteil (30) aufweist, durch den ein die Absolutposition der Maßverkörperung (3) repräsentierendes Absolutsignal erzeugbar ist.

11. Sensoranordnung nach Anspruch 10, dadurch gekennzeichet, daß das Absolutteil (30) eine Grob-Abtaststufe (31) und eine Fein-Abtaststufe (32) aufweist, deren Signale (A1, A2) einem Codewandler (43) zuführbar sind.

12. Sensoranordnung nach Anspruch 11, dadurch gekennzeichnet, daß die Fein-Abtaststufe (32) mindestens eine Sensoreinheit nach einem der Ansprüche 1 bis 10 aufweist.

13. Sensoranordnung nach Anspruch 11, dadurch gekennzeichnet, daß durch den Codewandler (43) ein digitales oder ein analoges Ausgangssignal oder Original-Kommutierungssignale erzeugbar sind.

14. Sensoranordnung nach einem der Ansprüche 10 bis 13, dadurch gekennzeichnet, daß die Grob-Abtaststufe (31) und/oder die Fein-Abtaststufe (32) und/oder der Codewandler (43) und/oder die Lichtquelle (2) auf den Halbleiterchip implementiert sind.

15. Verfahren zur Adaption einer Sensoreinheit eines Dreh- oder Lineargebers an eine auf einer Maßverkörperung (3) angeordnete Code-Teilung, bei dem in einer Betriebsphase das von einer Lichtquelle (2) emittierte und in mindestens einem Photoelement (25', 25a') mindestens einer Photoelemente-Anordnung (25', 25a) des Dreh- oder Lineargebers (1) registrierte Licht zur Bestimmung des Drehwinkels oder der Linearverschiebung ausgewertet wird, dadurch gekennzeichnet, daß in einer der Betriebsphase des Dreh- oder Lineargebers (1) vorangehenden Adaptionsphase eine Adaption der Sensoreinheit auf die durch die Codierungselemente der Maßverkörperung (3) vorgegebene Code-Teilung durchgeführt wird, indem eine auf die Code-Teilung der Maßverkörperung (3) abgestimmte Auswahl der Photoelemente (25', 25a') der mindestens einen Photoelemente-Anordnung (25', 25a) durchgeführt wird, indem in einer Abfolge von Teilschritten dieser Adaptionsphase die Photoelemente (25', 25a') der Photoelemente-Anordnung (25, 25a) jeweils einzeln oder in Gruppen von in dieser Adaptionsphase zusammenwirkenden Photoelementen (25', 25a') aktiviert werden, und daß aus der durch diese Abfolge von Einzelmessungen gewonnenen Verteilung der Lichtintensität über die einzelnen Photoelemente die auf die Code-Teilung der Maßverkörperung (3) abgestimmte Auswahl der Photoelemente (25', 25a') bestimmt wird.

16. Verfahren nach Anspruch 15, dadurch gekennzeichent, daß die in dieser Adaptionsphase erzeugte Auswahl der Photoelemente (25', 25a') in einem Speicher (27) einer mit der Photoelemente-Anordnung (25, 25a) zusammenwirkenden Schaltanordnungen (26, 26a) abgespeichert wird.

17. Verfahren nach einem der Ansprüche 15 oder 16, dadurch gekennzeichnet, daß die Adaptionsphase der Betriebsphase überlagert oder quasi-kontinuierlich oder in diskreten Zeitabständen wiederholt durchführbar ist.

18. Verfahren nach einem der Ansprüche 15 bis 17, dadurch gekenzeichnet, daß nach dieser ersten Adaptionsphase in einer weiteren Adaptionsphase ein Feinabgleich des Ausgangsignals (S, S'; S1, S1') der Sensoreinheit (21a, 21b; 31, 32) durchgeführt und die in dieser weiteren Adaptionsphase erzeugte Auswahl der Photoelemente (25', 25a') in dem Speicher (27) der Schaltanordnung (26, 26a) abgespeichert wird.

## Claims

1. Sensor unit for a rotary or linear encoder with at least one photocell assembly (25, 25a) having several photocells (25', 25a'), through which the encoding elements arranged on a portion of a material measure (3) detected by the photocell assembly (25, 25a) and exposed to the light beams of a light source (2) may be scanned, and wherein the output signals (S, S'; S1, S1') generated by the photocells (25', 25a') of the photocell assembly (25, 25a) may be fed into an evaluation circuit (11a, 11b), characterized in that circuitry (26, 26a) is connected in series to the photocell assembly (25a, 25a), through which circuitry the photocells (25' and 25a') of the photocell assembly (25, 25a) may be selectively activated and deactivated such that in an adaptation phase, a predefined portion of the encoding elements of the material measure (3) can be scanned by at least one photocell (25', 25a') of the photocell assembly (25, 25a), in order to establish essentially an allocation between each of the encoding elements of the material measure (3) und the photocell (25', 25a') allocated to this encoding element, that the output signals (A, A') of all of the photocells (25', 25a') of the photocell assembly (25, 25a) which are active at a given point in time, can be fed to the evaluation circuit (11a, 11b), and that through the evaluation circuit (11a, 11b) the output signals of the currently active photocells (25', 25a') of the photocell assembly (25a, 25a) may be registered, and that from the distribution of light intensity via the photocells (25', 25a') of the photocell assembly (25, 25a), which is obtained thereby, a selection of the photocells (25', 25a') to be activated at a predefined point in time, which selection is adapted to the structure of the encoding elements of the material measure (3), may be determined.

2. Sensor unit as claimed in Claim 1, characterized in that the circuitry of the photocells (25', 25a') may be selected by a selection process in such a way that from one photocell assembly (25, 25a) only output signals (A, A') can be generated which represent one single channel.

3. Sensor unit as claimed in Claim 1, characterized in that the circuitry of the photocells (25', 25a') may be selected by a selection process in such a way that from one photocell assembly (25, 25a) several out-of-phase output signals (A, A') can be generated on several channels.

4. Sensor unit as claimed in any one of Claims 1 to 3, characterized in that in the circuitry (26, 26a) information with regard to the photocells (25', 25a') of the photocell assembly (25, 25a), which are to be activated or deactivated at a predefined point in time, can be stored.

5. Sensor unit as claimed in Claim 4, characterized in that the circuitry (26, 26a) has at least one nonvolatile memory (27).

6. Sensor unit as claimed in any one of Claims 1 to 5, characterized in that the circuitry (26, 26a) has an interface via which the memory (27) of the circuitry (26, 26a) can be programmed.

7. Sensor unit as claimed in any one of Claims 1 to 6, characterized in that the circuitry (26, 26a) for each photocell (25', 25a') or for each group of co-operating photocells (25', 25a') has a switch (28'), the switching states of which can be stored in the memory (27) of the circuitry (26, 26a).

8. Sensor unit as claimed in any one of Claims 1 to 7, characterized in that the photocells (25', 25a') of the photocell assembly (25, 25a) are equidistantly arranged, or that the photocells (25') of the first photocell assembly (25) are arranged in a staggered manner relative to the photocells (25a') of the further photocell assembly (25a).

9. Sensor unit as claimed in any one of Claims 1 to 8, characterized in that the first photocell assembly (25) and/or the further photocell assembly (25a) as well as the first circuitry (26) and/or the further circuitry (26a) are implemented on a semiconductor chip, that the evaluation circuit (11a, 11b) processing the output signals (S, S'; S1, S1') of the photocell assembly (25, 25a) is implemented on the semiconductor chip, and that function blocks (18, 19) executing auxiliary functions for the photocells (25a, 25a') of the photocell assembly (25, 25a) are implemented on the semiconductor chip.

10. Sensor assembly having a sensor unit (21a, 21b) as claimed in at least one of Claims 1 to 9, characterized in that the sensor assembly (10) has an absolute part (30) through which an absolute signal representing the absolute position of the material measure (3) can be generated.

11. Sensor assembly as claimed in Claim 10, characterized in that the absolute part (30) has a coarse scanning stage (31) and a fine scanning stage (32), the signals (A1, A2) of which can be fed to a code converter (43).

12. Sensor assembly as claimed in Claim 11, characterized in that the fine scanning stage (32) has at least one sensor unit as claimed in any one of Claims 1 to 10.

13. Sensor assembly as claimed in Claim 11, characterized in that a digital or analog output signal or original commutation signal may be generated through the code converter (43).

14. Sensor assembly as claimed in any one of Claims 10 to 13, characterized in that the coarse scanning stage (31) and/or the fine scanning stage (32) and/or the code converter (43) and/or the light source (2) are implemented on the semiconductor chip.

15. Process for the adaptation of a sensor unit of a rotary or linear encoder to a code index arranged on a material measure (3), wherein in an operational phase, the light emitted from a light source (2) and registered in at least one photocell (25', 25a') of at least one photocell assembly (25', 25a) of the rotary or linear encoder (1) is evaluated for determining the angle of rotation or the linear displacement, characterized in that in an adaptation phase preceding the operational phase of the rotary or linear encoder (1), an adaptation of the sensor unit to the code index specified by the encoding elements of the material measure (3) is carried out by means of a selection of the photocells (25', 25a') of the at least one photocell assembly (25', 25a), which selection is adapted to the code index of the material measure (3), by activating in a sequence of part-steps of this adaptation phase the photocells (25', 25'a) of the photocell assembly (25, 25a) individually or in groups of photocells co-operating in this adaptation phase, and that from the distribution of the light intensity throughout the individual photocells, which is obtained by this sequence of individual measurements, the selection of the photocells (25', 25a') adapted to the code index of the material measure (3) is determined.

16. Process as claimed in Claim 15, characterized in that the selection of the photocells (25', 25a'), which was generated in this adaptation phase, is stored in a memory (27) of circuitries (26, 26a) co-operating with the photocell assembly (25, 25a).

17. Process as claimed in any one of Claims 15 or 16, characterized in that the adaptation phase may be carried out concurrently with the operational phase or quasi-continuously or intermittently in discrete time intervals.

18. Process as claimed in any one of Claims 15 to 17, characterized in that following this first adaptation phase, fine tuning of the output signal (S, S'; S1, S1') of the sensor unit (21a, 21b; 31, 32) is carried out in a further adaptation phase, and the selection of the photocells (25', 25a'), which is generated in this further adaptation phase, is stored in the memory (27) of the circuitry (26, 26a).

## Revendications

1. Unité de capteur pour un capteur de position angulaire ou linéaire, avec au moins un système de cellules photovoltaïques (25, 25a) présentant plusieurs cellules photovoltaïques (25', 25a'), qui permet de balayer des éléments de codage, disposés sur la section d'une mesure matérialisée (3), détectée par le système de cellules photovoltaïques (25, 25a) et mise sous charge par les rayons de lumière d'une source de lumière (2), et dans laquelle les signaux de départ (S, S'; S1, S1') produits par les cellules photovoltaïques (25', 25a') du système de cellules photovoltaïques (25, 25a) peuvent être amenés à un circuit sélecteur (11a, 11b), caractérisée en ce qu' en amont du système de cellules photovoltaïques (25a, 25a) est connecté un système de couplage (26, 26a), qui permet d'activer et de désactiver sélectivement les cellules photovoltaïques (25' et 25a') du système de cellules photovoltaïques (25, 25a), de sorte que dans une phase d'adaptation, une section définie des éléments de codage de la mesure matérialisée (3) peut être balayée par au moins une cellule photovoltaïque (25', 25a') du système de cellules photovoltaïques (25, 25a), afin de déterminer essentiellement une affectation entre chaque élément de codage de la mesure matérialisée (3) et la cellule photovoltaïque (25', 25a') affectée à cet élément de codage, en ce que les signaux de départ (A, A') de toutes les cellules photovoltaïques (25', 25a') du système de cellules photovoltaïques (25, 25a) actives à un instant donné peuvent être amenés au circuit sélecteur (11a, 11b), et en ce que par l'intermédiaire du circuit sélecteur (11a, 11b), les signaux de départ des cellules photovoltaïques (25', 25a') du système de cellules photovoltaïques (25, 25a) respectivement actives peuvent être enregistrés, et en ce qu'il est possible, à partir de la répartition de l'intensité lumineuse sur les cellules photovoltaïques (25', 25a') du système de cellules photovoltaïques (25, 25a) ainsi obtenue, de déterminer une sélection, adaptée à la structure des éléments de codage de la mesure matérialisée (3), des cellules photovoltaïques à activer à un instant défini.

2. Unité de capteur selon la revendication 1, caractérisée en ce que le système de couplage des cellules photovoltaïques (25', 25a') peut être sélectionné par un procédé de sélection de telle sorte qu'il est possible, à partir d'un système de cellules photovoltaïques (25, 25a), de produire des signaux de départ (A, A') représentant seulement un seul canal.

3. Unité de capteur selon la revendication 1, caractérisée en ce que le système de couplage des cellules photovoltaïques (25', 25a') peut être choisi par un procédé de sélection de telle sorte qu'il est possible, à partir d'un système de cellules photovoltaïques (25, 25a), de produire différents signaux de départ (A, A') avec décalage de phase sur des canaux différents.

4. Unité de capteur selon l'une quelconque des revendications 1 à 3, caractérisée en ce que dans le système de couplage (26, 26a), il est possible de mémoriser des informations concernant les cellules photovoltaïques (25', 25a') du système de cellules photovoltaïques (25, 25a) à activer ou à désactiver à un instant défini.

5. Unité de capteur selon la revendication 4, caractérisée en ce que le système de couplage (26, 26a) présente au moins une mémoire (27) non volatile.

6. Unité de capteur selon l'une quelconque des revendications 1 à 5, caractérisée en ce que le système de couplage (26, 26a) présente une interface à travers laquelle il est possible de programmer la mémoire (27) du système de couplage (26, 26a).

7. Unité de capteur selon l'une quelconque des revendications 1 à 6, caractérisée en ce que le système de couplage (26, 26a) présente pour chaque cellule photovoltaïque (25', 25a'), ou pour chaque groupe de cellules photovoltaïques (25', 25a') coopérant, un commutateur (28') dont les états de commutation peuvent être mémorisés dans la mémoire (27) du système de couplage (26, 26a).

8. Unité de capteur selon l'une quelconque des revendications 1 à 7, caractérisée en ce que les cellules photovoltaïques (25', 25a') du système de cellules photovoltaïques (25', 25a') sont disposées de façon équidistante, ou en ce que les cellules photovoltaïques (25') du premier système de cellules photovoltaïques (25) sont disposées de façon graduée par rapport aux cellules photovoltaïques (25a') de l'autre système de cellules photovoltaïques (25a).

9. Unité de capteur selon l'une quelconque des revendications 1 à 8, caractérisée en ce que le premier système de cellules photovoltaïques (25) et/ou l'autre système de cellules photovoltaïques (25a) ainsi que le premier système de couplage (26) et/ou l'autre système de couplage (26a) sont mis en oeuvre sur une pastille à semi-conducteur, en ce que sur la pastille à semi-conducteur est mis en oeuvre le circuit sélecteur (11a, 11b) qui traite les signaux de départ (S, S'; S1, S1') du système de cellules photovoltaïques (25, 25a), et en ce que sur la pastille à semi-conducteur sont mis en oeuvre des blocs de fonction (18, 19) qui exécutent des fonctions auxiliaires pour les cellules photovoltaïques (25a, 25a') du système de cellules photovoltaïques (25a, 25a').

10. Système de capteurs avec une unité de capteur (21a, 21b) selon au moins l'une quelconque des revendications 1 à 9, caractérisé en ce que le système de capteurs (10) présente une pièce absolue (30) qui permet de produire un signal absolu représentant la position absolue de la mesure matérialisée (3).

11. Système de capteurs selon la revendication 10, caractérisé en ce que la pièce absolue (30) présente un niveau de balayage grossier (31) et un niveau de balayage fin (32), dont les signaux (A1, A2) peuvent être amenés à un convertisseur de code (43).

12. Système de capteurs selon la revendication 11, caractérisé en ce que le niveau de balayage fin (32) présente au moins une unité de capteur selon l'une quelconque des revendications 1 à 10.

13. Système de capteurs selon la revendication 11, caractérisé en ce que le convertisseur de code (43) permet de produire un signal de départ numérique ou analogique ou des signaux de commutation d'origine.

14. Système de capteurs selon l'une quelconque des revendications 10 à 13, caractérisé en ce que le niveau de balayage grossier (31) et/ou le niveau de balayage fin (32) et/ou le convertisseur de code (43) et/ou la source de lumière sont mis en oeuvre sur la pastille à semi-conducteur.

15. Procédé pour adapter une unité de capteur d'un capteur de position angulaire ou linéaire à une division de codes disposée sur une mesure matérialisée (3), dans lequel, au cours d'une phase d'exploitation, la lumière émise par une source de lumière (2) et enregistrée dans au moins une cellule photovoltaïque (25', 25a') d'au moins un système de cellules photovoltaïques (25', 25a) du capteur de position angulaire ou linéaire (1) est interprétée pour déterminer l'angle de rotation ou le déplacement linéaire, caractérisé en ce que, dans une phase d'adaptation, précédant la phase d'exploitation du capteur de position angulaire ou linéaire (1), une adaptation de l'unité de capteur à la division de codes donnée par les éléments de codage de la mesure matérialisée (3), en effectuant une sélection des cellules photovoltaïques (25', 25a') d'au moins un système de cellules photovoltaïques (25', 25a) adaptée à la division de codes de la mesure matérialisée (3), en activant dans une suite d'étapes partielles de cette phase d'adaptation les cellules photovoltaïques (25', 25a') du système de cellules photovoltaïques (25, 25a) respectivement individuellement ou par groupes de cellules photovoltaïques (25', 25a') coopérant dans cette phase d'adaptation, et en ce qu'à partir de la répartition de l'intensité lumineuse sur les différentes cellules photovoltaïques, obtenue par cette suite de mesures individuelles, la sélection des cellules photovoltaïques (25', 25a') adaptée à la division de codes de la mesure matérialisée (3) est déterminée.

16. Procédé selon la revendication 15, caractérisé en ce que la sélection de cellules photovoltaïques (25', 25a') produite au cours de cette phase d'adaptation est mémorisée dans une mémoire (27) d'un système de couplage (26, 26a) coopérant avec le système de cellules photovoltaïques (25, 25a).

17. Procédé selon l'une quelconque des revendications 15 ou 16, caractérisé en ce que la phase d'adaptation peut être exécutée de façon superposée à la phase d'exploitation ou de façon presque continue ou de façon répétée à intervalles de temps discrets.

18. Procédé selon l'une quelconque des revendications 15 à 17, caractérisé en ce que dans une autre phase d'adaptation, après cette première phase d'adaptation, un ajustement fin du signal de départ (S, S'; S1, S1') de l'unité de capteur (21a, 21b; 31, 32) est effectué et la sélection des cellules photovoltaïques (25', 25a') produite dans cette phase d'adaptation supplémentaire est mémorisée dans la mémoire (27) du système de couplage (26, 26a).
